# FASCICULE DE BREVET EUROPEEN

(11) **EP 3 350 931 B1**
(45) Date de publication et mention de la délivrance du brevet: **07.02.2024**
(21) Numéro de dépôt: 16777730.9
(22) Date de dépôt: 15.09.2016
(51) Int. Cl.: H03M 13/37, H04L 1/18, H04N 19/895, H04N 21/6405, H04N 21/6408, H04N 21/6375, H04N 21/438

(54) **PROCÉDÉ D'OPTIMISATION DE TRANSMISSION DE FLUX DE DONNÉES VIDÉO DANS UN RÉSEAU SANS FIL**
OPTIMISIERTE ÜBERTRAGUNG VON VIDEODATEN ÜBER EIN DRAHTLOSES NETZWERK
OPTIMISED TRANSMISSION OF VIDEO DATA OVER A WIRELESS NETWORK

(30) Priorité: 16.09.2015 FR 1558670
(43) Date de publication de la demande: 25.07.2018
(73) Titulaire: Vogo, 34000 Montpellier (FR)
(72) Inventeur: KEIFLIN, Pierre, 34130 Carnon (FR); CARNIEL, Christophe, 34170 Castelnau Le Lez (FR); DEDISSE, Daniel, 34730 Prades Le Lez (FR)
(74) Mandataire: Rhein, Alain
(86) Numéro de dépôt international: PCT/FR2016/052331
(87) Numéro de publication internationale: WO 2017/046528

(56) Documents cités:
- WO-A1-2012/054570
- WO-A2-2008/006014
- KR-B1- 100 860 770
- US-A1- 2002 114 283
- US-A1- 2007 153 898
- WUTTIPONG KUMWILAISAK ET AL: "Spatial error concealment with sequence-aligned texture modeling and adaptive directional recovery", JOURNAL OF VISUAL COMMUNICATION AND IMAGE REPRESENTATION, ACADEMIC PRESS, INC, US, vol. 22, no. 2, 7 décembre 2010 (2010-12-07), pages 164-177, XP028137413, ISSN: 1047-3203, DOI: 10.1016/J.JVCIR.2010.12.002 [extrait le 2010-12-13]
- ZHI LI ET AL: "Forward and retransmitted Systematic Lossy Error Protection for IPTV video multicast", PACKET VIDEO WORKSHOP, 2009. PV 2009. 17TH INTERNATIONAL, IEEE, PISCATAWAY, NJ, USA, 11 mai 2009 (2009-05-11), pages 1-9, XP031483135, ISBN: 978-1-4244-4651-3

## Description

La présente invention a trait à un procédé d'amélioration de la fiabilité et de la qualité de réception de flux de données vidéo sur un réseau numérique sans fil entre autres, régi par des protocoles de communication par exemple de type WIFI. Les flux concernés sont envoyés en multicast, ou multidiffusion, c'est-à-dire qu'ils proviennent d'au moins un émetteur les diffusant vers des récepteurs d'un groupe abonné à ladite diffusion. Les dispositifs récepteurs, ou clients, formant le groupe destinataire sont capables de visualiser les flux envoyés, et sont dotés à cet effet d'au moins une application permettant de traiter et de visualiser l'information reçue.

Plus particulièrement, la présente invention porte sur un traitement, réalisé à la réception de flux vidéos, permettant d'améliorer la qualité des signaux décodés en présence de pertes de blocs de données.

L'une des applications possibles de l'invention est la diffusion pratiquement en temps réel d'événements de type rencontres sportives ou spectacles, dans le périmètre de l'enceinte où a lieu ledit événement. Le logiciel applicatif client permet d'une part la visualisation fluide des images vidéos proposées entre autres par un prestataire lié à l'organisateur de l'évènement, et d'autre part d'enrichir la visualisation par des traitements susceptibles de conférer une valeur ajoutée aux flux vidéo reçus, par exemple une répétition et donc une revisualisation de certaines séquences, le cas échéant au ralenti.

De tels traitements impliquent que les flux vidéos, classiquement transmis sous forme de paquets d'informations contenant essentiellement des groupes d'images, soient réceptionnés en une qualité suffisante d'abord pour que leur visualisation soit simplement confortable, puis également pour que les éventuels traitements ultérieurs des signaux puissent se baser sur un socle d'information suffisant à leur réalisation.

Or, sur les réseaux locaux sans fil, quelque soit les protocoles de communication utilisés et le mode de diffusion - cela s'applique donc également aux réseaux WIFI en diffusion multicast qui seront utilisés dans le texte comme exemple préférentiel - le taux d'erreur de transmission est compris entre 0% et 15%, parfois plus. Ce taux d'erreur consiste en pratique en une perte de blocs d'informations transmis par le réseau. Dans l'hypothèse de transmissions de flux vidéo, le résultat de ces pertes est une mauvaise qualité des vidéos obtenues, les images pouvant présenter des macroblocs exogènes qui les dégradent et dégradent par conséquent la qualité des flux, quand elles ne sont pas purement et simplement perdues. Selon le cas, ces pertes peuvent altérer le flux vidéo jusqu'à empêcher la diffusion de certaines séquences.

En pratique, les flux de données vidéo sont codés sous forme de paquets G qui sont en réalité essentiellement constitués de groupes d'images de différentes catégories, ces paquets étant ensuite divisés en des blocs de données. Selon un schéma classique, qui résulte d' ailleurs de la mise en oeuvre par avance de conditions de récupération de données perdues, ces paquets G comportent chacun K premiers blocs de données qui codent essentiellement les images du flux vidéo et N blocs dits de redondance utilisables le cas échéant pour la correction d'erreur directe (par un algorithme de type FEC) .

Un flux comprend donc une succession de groupe d'images ou paquets G comportant chacun K+N blocs émise par le dispositif émetteur, qui l'envoie en multicast à des dispositifs de visualisation clients, par exemple des smartphones ou des tablettes.

Pour assurer une réception fiable et de qualité des flux vidéo, malgré les pertes toujours possibles, le procédé comporte selon l'invention et à titre principal les étapes suivantes, mise en oeuvre par chaque dispositif client pour chacun des paquets G de données reçu du ou des dispositifs émetteurs:
- a/ contrôle de la réception correcte des K premiers blocs de données, décodage et visualisation du flux vidéo en cas de résultat positif ;
- b/ en l'absence de réception de la totalité des K premiers blocs de données, et si le nombre total X de blocs K+N reçus est au moins égal à K, décodage au moyen d'un algorithme de correction d'erreur directe (FEC) pour retrouver les données manquantes des blocs K, décodage et visualisation du flux vidéo en cas de résultat positif ;
- c/ si le nombre total X de blocs K+N reçus est inférieur à K ou en l'absence de résultat positif au décodage via l'algorithme de correction d'erreur directe (FEC), envoi par le dispositif client d'un message unicast donnant à l'émetteur des informations au moins sur le ou les blocs perdus ;
- d/ si un algorithme statistique du dispositif émetteur organise le renvoi des données manquantes, contrôle de la réception correcte des données renvoyées par le dispositif émetteur selon a/ et b/, décodage et visualisation du flux vidéo en cas de résultat positif.

L'idée à la base de l'invention est de tenter de corriger les erreurs par étapes successives, la mise en oeuvre de chacune des étapes dépendant d'au moins un test effectué à l'étape précédente. La mise en oeuvre des étapes dépend notamment du taux et de la répartition des erreurs détectées dans les paquets de données. Dans une hypothèse favorable, seule la première étape, c'est-à-dire le premier test, est mise en oeuvre. Si la totalité des K premiers blocs est parvenue au dispositif client, cela signifie qu'il n'y a pas d'erreur, pas de perte d'information, et le décodage vidéo peut s'effectuer en vue de la visualisation.

Dans une hypothèse plus défavorable, il faut faire appel à l'algorithme FEC pour retrouver des données manquantes : cette étape permet en fait de corriger les pertes de blocs réparties dans le temps, lorsque le taux d'erreur n'est pas trop important (il est alors qualifié de faible à moyen) . La condition de mise en oeuvre de cette étape est que le nombre total de blocs reçus est au moins égal à K. Ce comptage des blocs est une caractéristique qui ne se retrouve pas dans l'art antérieur ayant trait à des problématiques similaires, comme par exemple le document WO2008/006014.

Selon la typologie des erreurs, cette étape peut tout à fait être soit un échec soit non réalisable par manque de données, et donc ne pas permettre de corriger les erreurs : c'est par exemple le cas lorsqu'il se produit des erreurs par exemple par paquets entiers, c'est à dire des erreurs regroupées, représentant un taux d'erreur qualifié de moyen à élevé. Une autre routine est alors à mettre en oeuvre, selon l'invention, qui suppose un échange avec le dispositif émetteur. Le client qui se trouve dans ce cas envoie un message en unicast à l'émetteur, lequel renvoie éventuellement les données manquantes suivant un algorithme statistique. Cela suppose évidemment que celles-ci aient été identifiées par le dispositif client.

L'intégrité ou la lisibilité des données renvoyées est contrôlée selon les étapes a/ et b/ à la réception par le dispositif client, qui peut alors procéder au décodage du flux en vue de sa visualisation.

Le procédé de l'invention va cependant plus loin, et considère également l'hypothèse selon laquelle les données renvoyées par le dispositif émetteur ne sont toujours pas réceptionnées ou ne sont pas réceptionnées suffisamment rapidement, dans des conditions permettant d'afficher correctement le flux vidéo.

Dans ce cas, les étapes suivantes sont mises en oeuvre selon l'invention :
- e/ en l'absence de réception correcte des données renvoyées , contrôle de la réception d'une image de référence à codage interne dans le paquet G de données reçues, puis
- f/ si une telle image de référence est reçue complètement mise en oeuvre d'un algorithme de dissimulation d'erreur appliqué sur des flux de données compressées, et
- g/ décodage et visualisation du flux vidéo.

L'image de référence à laquelle il est fait allusion est celle avec laquelle commence typiquement le paquet G, essentiellement formé d'un groupe d'images dont la succession, répétée périodiquement jusqu'à la fin de l'encodage, constitue *in fine* le flux vidéo encodé. C'est une image de référence à codage interne dont le décodage est autonome et ne dépend pas des images précédentes ou suivantes. Cette catégorie est utilisée en association avec des images d'autres catégories, par exemple à codage prédictif, dans un ordre qui définit un groupe particulier. Les images visibles sont ensuite générées (ou décodées) à partir des images codées contenues dans ce groupe prédéfini.

Ce type d'image, indépendant des autres types d'image constituant le groupe, est considéré comme image de référence, et le test visant à déterminer la pertinence de la mise en oeuvre d'un algorithme de dissimulation d'erreur est donc de préférence, selon l'invention, basé sur l'existence complète d'une telle image de référence.

Lorsqu'un dispositif client n'a pas pu reconstruire correctement le flux vidéo renvoyé par le dispositif émetteur, il met en oeuvre une étape de dissimulation d'erreurs. Celle-ci n'est cependant effectuée qu'à la condition qu'une image de référence ait été reçue dans le paquet de données G traité. Cette nouvelle étape basée sur la dissimulation permet de dissimuler les erreurs et de fournir, au moment du décodage, des échantillons encodés et calculés qui remplacent les échantillons manquants du signal à partir des données de l'image de référence et des éventuelles autres images reçues dans le paquet G. L'estimation des parties manquantes des images sur les données encodées permet d'atténuer visuellement les erreurs de réception de données dans les flux vidéo compressés, et s'effectue en exploitant les corrélations spatiales et temporelles entre images, soit à l'intérieur d'une même image (corrélation spatiale) soit dans les images passées ou futures (corrélation temporelle). L'idée à la base de ces routines est qu'il y a rarement des changements brutaux entre pixels spatialement adjacents d'une image, et qu'il y a une continuité temporelle dans les images successives d'une séquence vidéo.

Le procédé de l'invention envisage ensuite la possibilité de la non réception d'une telle image référence à codage interne dans le paquet de données du flux en cours de traitement. Dans ce cas, selon une possibilité propre à l'invention, les étapes suivantes sont mises en oeuvre :
- h/ en cas de non réception d'une image de référence à codage interne dans le paquet G de données reçues, vérification de la réception d'au moins une image de référence des paquets précédents G-1 et suivant G+1,
- i/ mise en oeuvre d'un procédé d'interpolation agissant sur des flux vidéo de données non compressées ou linéaires pour la reconstruction d'images, puis
- j/ décodage et visualisation du flux vidéo.

Ce nouvel étage du procédé de l'invention utilise cette fois des possibilités de reconstruction algorithmique plutôt que des techniques de dissimulation d'erreurs utilisées ci-dessus, dans un contexte un peu différent. Il s'agit de méthodes d'interpolation qui sont également envisagées de manière temporelle ou spatiale, et fonctionnent cette fois avec des flux vidéo non compressés. Dans une interpolation temporelle, elles permettent de générer des images manquantes dans un flux en utilisant les images précédentes et suivantes.

S'il advient qu'aucune des étapes décrites précédemment ne permet d'aboutir, en particulier dans le cadre de la dernière étape mise en oeuvre, parce qu'il n'y a pas réception d'au moins une image de référence des paquets précédent G-1 et suivant G+1, le paquet G n'est pas affiché.

Le procédé de l'invention est en réalité une chaîne de solutions successives visant à adapter la réponse du système à des défauts de transmission du signal vidéo dont la nature et gravité sont décelées de manière progressive. Cette chaîne de solutions, telle que précisément mise en oeuvre, ne résulte pas de l'art antérieur connu, par exemple constitué des documents US2007153898, XP028137413 et WO2012054570.

L'invention va à présent être décrite plus en détail, en référence aux figures annexées, représentant une possibilité de mise en oeuvre du procédé de l'invention, et pour lesquelles :
- la figure 1 représente un organigramme schématisant la mise en oeuvre globale du procédé de l'invention ; et
- la figure 2 montre un même paquet de données, constituant un encodage possible d'un groupe d'images et, par répétition, un flux vidéo, différents types de pertes de données possibles étant représentés sur ces paquets de données.

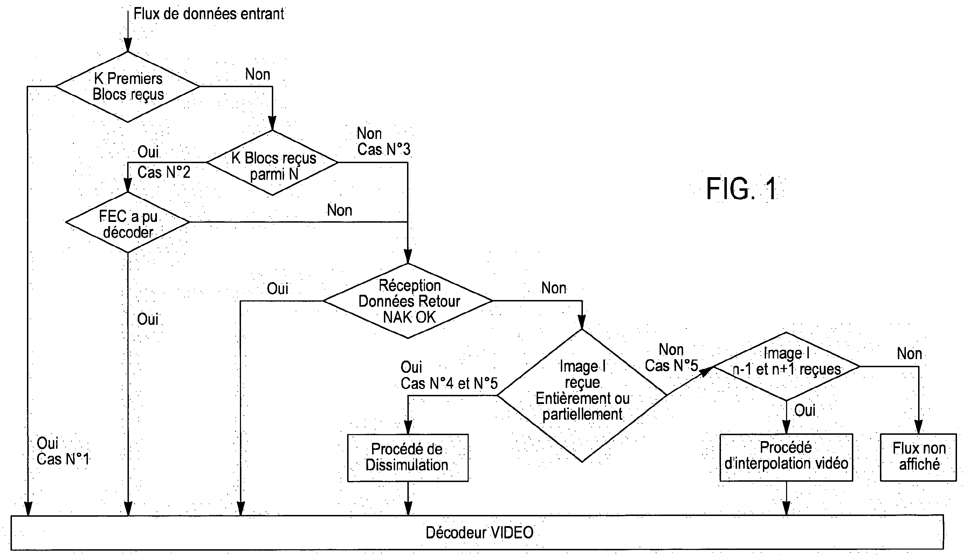

En référence à la figure 1, le premier test effectué dans le cadre du procédé consiste à vérifier si les K premier blocs ont été reçus. A chaque étape, après chaque test, dans une hypothèse favorable, c'est-à-dire s'il n'y a pas de problème de perte de données, ou s'ils ont été résolus, les paquets de données constituant le flux vidéo sont traités par le décodeur vidéo en vue de la diffusion du flux transmis.

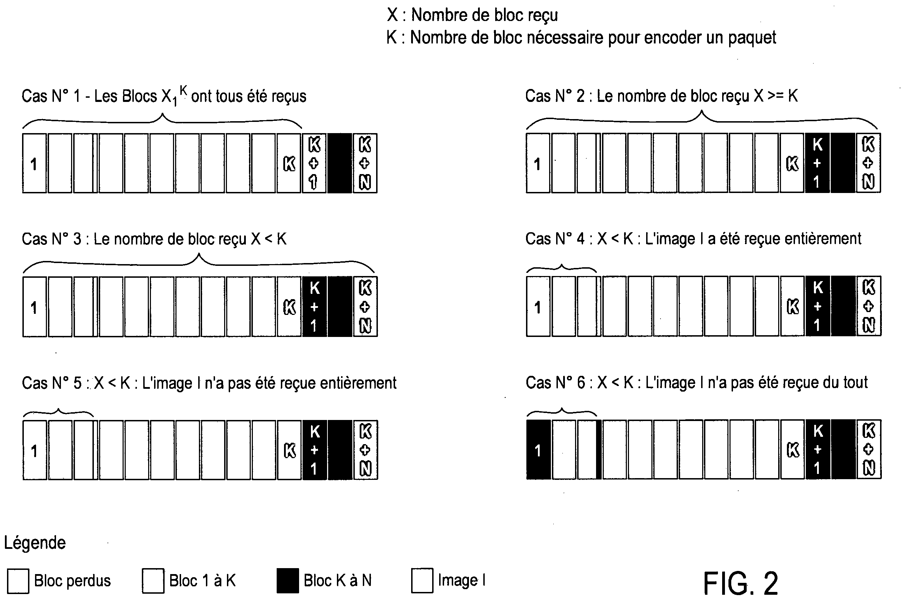

Si le résultat au premier test est positif, cela signifie notamment que le paquet de données correspond au cas N°1 de la figure 2, selon lequel les K premiers blocs du paquet de données ont été reçus. En figure 2 un code visuel définit les différents blocs, apparaissant dans la légende figurant au bas de la figure, et comprenant les premiers blocs K, les blocs K à N, les images de référence I et les blocs perdus.

Dans un hypothèse négative, le test suivant porte sur le nombre X de blocs reçus parmi l'ensemble des blocs K + N émis, c'est-à-dire incluant les blocs de redondance N, placés à la suite des blocs K dans les représentations de la figure 2. Si le nombre total de blocs reçus est au moins égal à K (même en cas d'erreurs, de blocs perdus), c'est-à-dire si X ≥ K, correspondant au cas N°2 de la figure 2, un algorithme de correction d'erreur directe (FEC) est mis en oeuvre, puis un nouveau test de vérification est implémenté. Comme il s'agit d'un type de correction qui est adapté à des pertes réparties dans le temps, sur l'ensemble du paquet de données, c'est-à-dire sur l'ensemble des blocs N+K, cette stratégie de correction d'erreur ne fonctionne pas nécessairement.

Si ce test est négatif, ce qui peut signifier que les pertes de données sont plutôt concentrées et non pas réparties, ou si le nombre X de blocs reçus parmi les N+K blocs est inférieur à K - correspondant au cas N°3 de la figure 2 - une procédure (dite NAK) de rappel des données non reçues est lancée. Cette routine implique une communication unicast en sens inverse, entre un des dispositifs clients de réception et un dispositif émetteur, et nécessite une identification des données manquantes.

Ce dernier renvoie en unicast ou en multicast les données identifiées par le client comme non reçues suivant un algorithme statistique, et un nouveau test de réception correcte est réalisé dans le dispositif client. Le test suivant concerne la réception correcte d'une image de référence I à codage interne par paquet ou groupe d'images i. En figure 2, l'image de référence I est placée en début du paquet, ce qui est très généralement la place qu'elle occupe dans de tels encodages. Si cette image I est complètement ou partiellement reçue, c'est-à-dire dans les cas N°4 et N°5 illustrés en figure 2, les erreurs de transmission constatées et qui n'ont pas été résolues dans les étapes précédentes sont traitées au moyens d'un algorithme de dissimulation. Les erreurs sont dans ce cas dissimulées au niveau du décodeur vidéo, mais pas corrigées. L'objectif de ce type de routines, qui agit sur les flux de données compressés, est d'atténuer visuellement les erreurs de réception dans les flux vidéo.

Dans l'hypothèse inverse, c'est-à-dire s'il n'y a pas de réception d'une image de référence à codage interne I dans le groupe d'images ou paquet G, le procédé de l'invention teste la réception d'une telle image de référence I dans les paquets ou groupes d'images G-1 et G+1. Cela correspond au cas N°6 de la figure 2. Si c'est le cas, une reconstruction des images détériorées peut encore être mise en oeuvre, sur la base d'un algorithme d'interpolation agissant sur les flux vidéo non compressés, et générant les images manquantes ou les parties d'image manquantes respectivement en utilisant les images immédiatement précédentes ou suivantes dans la succession d'images, dans une perspective temporelle, ou en utilisant les parties de la même image immédiatement adjacentes à celles qui manquent, dans une perspective spatiale.

Lorsqu'aucun de ces traitements successifs ne réussit de manière satisfaisante, le paquet ou groupe d'images n'est pas affiché.

L'invention ne se limite bien entendu pas aux exemples décrits et expliqués en référence aux figures, mais elle englobe les variantes et versions qui entrent dans la portée des revendications.

## Revendications

1. Procédé d'amélioration de la fiabilité et de la qualité de réception de flux de données vidéos sur un réseau sans fil régi par des protocoles de communication de type WIFI, le flux de données vidéos étant codé sous forme de paquets G comportant chacun K premiers blocs de données et N blocs de redondance pour la correction d'erreur directe, FEC, ledit flux comprenant une succession de paquets G comportant chacun K+N blocs étant émis par au moins un dispositif émetteur l'envoyant en multicast à des dispositifs de visualisation clients de type smartphone, procédé comportant les étapes suivantes, mises en oeuvre par le dispositif client pour chacun des paquets G de données reçues du ou des dispositifs émetteurs :
- a/ contrôle de la réception correcte des K premiers blocs de données, décodage et visualisation du flux vidéo en cas de résultat positif ;
- b/ en l'absence de réception de la totalité des K premiers blocs de données, et si le nombre total X de blocs K+N reçus est au moins égal à K, décodage au moyen d'un algorithme de correction d'erreur directe pour retrouver les données manquantes des blocs K, décodage et visualisation du flux vidéo en cas de résultat positif ;
- c/ si le nombre total X de blocs K+N reçus est inférieur à K ou en l'absence de résultat positif au décodage via l'algorithme de correction d'erreur directe , envoi par le dispositif client d'un message unicast donnant à l'émetteur des informations au moins sur le ou les blocs perdus ;
- d/ si un algorithme statistique du dispositif émetteur organise le renvoi des données manquantes, contrôle de la réception correcte des données renvoyées par le dispositif émetteur selon a/ et b/, décodage et visualisation du flux vidéo en cas de résultat positif ;
procédé **caractérisé par** :
- e/ en l'absence de réception correcte des données renvoyées selon d/ ou en l'absence de données renvoyées, contrôle de la réception d'une image de référence à codage interne dans le paquet G de données reçue, puis
- f/ si une telle image de référence est reçue complètement, mise en oeuvre d'un algorithme de dissimulation d'erreur appliqué sur des flux de données compressées, et
- g/ décodage et visualisation du flux vidéo ;
- h/ en cas de non réception d'une image de référence à codage interne dans le paquet G de données reçue, vérification de la réception d'au moins une image de référence des paquets précédent G-1 et suivant G+1,
- i/ mise en oeuvre d'un procédé d'interpolation agissant sur des flux vidéo de données non compressées ou linéaires pour la reconstruction d'images, puis
- j/ décodage et visualisation du flux vidéo.

2. Procédé d'amélioration de la fiabilité et de la qualité de réception de flux de données vidéos sur un réseau local sans fil selon la revendication précédente, **caractérisée en ce que**, en cas d'incomplétude de réception d'au moins une image de référence des paquets précédent G-1 et suivant G+1, le paquet G n'est pas affiché.

## Patentansprüche

1. Verfahren zum Verbessern der Zuverlässigkeit und der Qualität des Empfangs von Videodatenströmen in einem drahtlosen Netzwerk, das durch Kommunikationsprotokolle einer WLAN-Art geregelt wird, wobei der Videodatenstrom in Form von Paketen G codiert ist, die jeweils K erste Datenblöcke und N Redundanzblöcke für die direkte Fehlerkorrektur, FEC, aufweisen, der Strom umfassend eine Folge von Paketen G, die jeweils K+N Blöcke aufweisen, die durch mindestens eine Sendevorrichtung gesendet wird, die diese in einem Multicast-Verfahren an Client-Anzeigevorrichtungen einer Smartphone-Art schickt, wobei das Verfahren die folgenden Schritte aufweist, die durch die Client-Vorrichtung für jedes der Datenpakete G durchgeführt werden, die von der oder den Sendevorrichtung(en) empfangen werden:
- a/ Prüfen des korrekten Empfangs der K ersten Datenblöcke, Decodieren und Anzeigen des Videostroms im Falle eines positiven Ergebnisses;
- b/ bei fehlendem Empfang der Gesamtheit der K ersten Datenblöcke und falls die Gesamtzahl X der empfangenen Blöcke K+N mindestens gleich K ist, Decodieren mittels eines Algorithmus zur direkten Fehlerkorrektur zum Finden der fehlenden Daten der Blöcke K, Decodieren und Anzeigen des Videostroms im Falle eines positiven Ergebnisses;
- c/ falls die Gesamtzahl X der empfangenen Blöcke K+N kleiner als K ist oder bei fehlendem positiven Ergebnis der Decodierung über den Algorithmus zur direkten Fehlerkorrektur, Schicken einer Unicast-Nachricht durch die Client-Vorrichtung, die dem Sender Informationen mindestens über den verlorenen Block oder die verlorenen Blöcke liefert;
- d/ falls ein statistischer Algorithmus der Sendevorrichtung die Rücksendung der fehlenden Daten organisiert, Prüfen des korrekten Empfangs der zurückgesandten Daten durch die Sendevorrichtung gemäß a/ und b/, Decodieren und Visualisieren des Videostroms im Falle eines positiven Ergebnisses;
Verfahren, **gekennzeichnet durch:**
- e/ bei fehlendem korrekten Empfang der zurückgesandten Daten gemäß d/ oder bei fehlenden zurückgesandten Daten, Prüfen des Empfangs eines Referenzbilds mit interner Codierung in dem empfangenen Datenpaket G, dann
- f/ falls ein solches Referenzbild vollständig empfangen wird, Durchführen eines Algorithmus zur Verdeckung von Fehler, der auf komprimierte Datenströme angewendet wird, und
- g/ Decodieren und Anzeigen des Videostroms;
- h/ bei Nichtempfang eines Referenzbilds mit interner Codierung in dem empfangenen Datenpaket G, Verifizieren des Empfangs von mindestens einem Referenzbild der vorhergehenden Pakete G-1 und der nachfolgenden Pakete G+1,
- i/ Durchführen eines Interpolationsverfahrens, das auf Videoströme unkomprimierter oder linearer Daten für die Rekonstruktion von Bildern einwirkt, dann
- j/ Decodieren und Anzeigen des Videostroms.

2. Verfahren zum Verbessern der Zuverlässigkeit und der Qualität des Empfangs von Videodatenströmen in einem drahtlosen lokalen Netzwerk nach dem vorstehenden Anspruch, **dadurch gekennzeichnet, dass** im Falle der Unvollständigkeit des Empfangs von mindestens einem Referenzbild der vorhergehenden Pakete G-1 und der nachfolgenden Pakete G+1 das Paket G nicht gezeigt wird.

## Claims

1. A method for improving the reliability and quality of receiving video data streams over a wireless network governed by WIFI communication protocols, the video data stream being coded in the form of packets G each comprising K first data blocks and N redundancy blocks for forward error correction (FEC), said stream comprising a succession of packets G each comprising K+N blocks being transmitted by at least one transmitter device which sends same, by multicasting, to client viewing devices of the smartphone type, the method comprising the following steps, implemented by the client device for each of the packets G of data received from the transmitter device(s):
- a/ checking for the correct reception of the K first data blocks, and decoding and viewing the video stream in the event of a positive result;
- b/ in the absence of all of the K first data blocks being received, and if the total number X of received blocks K+N is at least equal to K, decoding by means of a forward error correction algorithm in order to retrieve the missing data of the blocks K, and decoding and viewing the video stream in the event of a positive result;
- c/ if the total number X of received blocks K+N is less than K or in the absence of a positive result for the decoding via the forward error correction algorithm, sending, by means of the client device, a unicast message which gives the transmitter information at least regarding the lost block(s);
- d/ if a statistical algorithm of the transmitter device organizes the return of the missing data, checking for the correct reception of the data returned by the transmitter device according to a/ and bl, and decoding and viewing the video stream in the event of a positive result;
the method being **characterized by**:
- e/ in the absence of the correct reception of the data returned according to d/ being correctly received or in the absence of returned data, checking for the correct reception of an internal coding reference image in the packet G of received data, then
- f/ if such a reference image is received completely, implementing an error concealment algorithm applied to compressed data streams, and
- g/ decoding and viewing the video stream;
- h/ in the event of non-reception of an internal coding reference image in the packet G of received data, verifying the reception of at least one reference image of the preceding packets G-1 and following packets G+1,
- i/ implementing an interpolation method which acts on video streams of uncompressed or linear data for the reconstruction of images, then
- j/ decoding and viewing the video stream.

2. Method for improving the reliability and the quality of receiving video data streams over a wireless local area network according to the preceding claim, **characterized in that**, in the event of incomplete reception of at least one reference image of the preceding packets G-1 and following packets G+1, the packet G is not displayed.
